(19) Europäisches Patentamt / European Patent Office / Office européen des brevets

(11) **EP 3 557 050 B1**

(12) **EUROPEAN PATENT SPECIFICATION**

(45) Date of publication and mention
of the grant of the patent:
**15.03.2023 Bulletin 2023/11**

(21) Application number: **17881919.9**

(22) Date of filing: **03.07.2017**

(51) International Patent Classification (IPC):
**F03D 17/00** (2016.01)   **G01M 1/16** (2006.01)
**G01R 31/34** (2006.01)

(52) Cooperative Patent Classification (CPC):
**G01M 1/16; F03D 17/00;** G01R 31/343

(86) International application number:
**PCT/CN2017/091412**

(87) International publication number:
**WO 2018/107726 (21.06.2018 Gazette 2018/25)**

(54) **DOUBLY-FED WIND TURBINE BLADE IMBALANCE DETECTION METHOD BASED ON STATOR CURRENT DATA**

DOPPELT GESPEISTES VERFAHREN ZUR ERKENNUNG DER UNWUCHT VON SCHAUFELN EINER WINDTURBINE BASIEREND AUF STATORSTROMDATEN

PROCÉDÉ DE DÉTECTION DE DÉSÉQUILIBRE DE PALE D'UNE ÉOLIENNE À DOUBLE ALIMENTATION BASÉ SUR DES DONNÉES DE COURANT DE STATOR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2016 CN 201611143926**

(43) Date of publication of application:
**23.10.2019 Bulletin 2019/43**

(73) Proprietor: **Zhejiang Windey Co., Ltd.**
**Hangzhou, Zhejiang 311106 (CN)**

(72) Inventors:
• **YE, Hangye**
**Hangzhou**
**Zhejiang 310012 (CN)**
• **XU, Guodong**
**Hangzhou**
**Zhejiang 310012 (CN)**
• **QIU, Jixing**
**Hangzhou**
**Zhejiang 310012 (CN)**

(74) Representative: **V.O.**
**P.O. Box 87930**
**2508 DH Den Haag (NL)**

(56) References cited:
WO-A1-2016/034180     CN-A- 102 954 857
CN-A- 103 234 702      CN-A- 103 759 891
CN-A- 104 184 383      CN-A- 105 221 353
CN-A- 105 756 864      CN-A- 106 052 957
CN-A- 106 523 299      DE-A1-102011 086 608
US-A1- 2011 036 166    US-A1- 2016 033 580

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present application claims the priority to Chinese Patent Application No. 201611143926.1, titled "DOUBLY-FED WIND TURBINE BLADE IMBALANCE DETECTION METHOD BASED ON STATOR CURRENT DATA", filed on December 13, 2016 with the Chinese Patent Office.

## FIELD

The present application relates to the technical field of online fault detection of a wind power generator system, and in particular to a method for detecting blade imbalance of a doubly-fed power generator system based on stator current data.

## BACKGROUND

Generally, wind power generator systems operate in a severe environment, in which blade imbalance in mass may occur due to acts of wind, sand and ice. Further, in recent years, with the increase in capacity of a wind power generator system and the application of a low-wind-speed wind power generator system, long blades are used. The imbalance of an impeller, including aerodynamic imbalance, is transferred to a transmission chain easily, which may result in an aggravate vibration of the whole wind power generator system, and even result in an accident.

It is difficult to construct an accurate detection model due to differences between blades and complicated fault mechanisms. In a conventional detection method based on a fixed threshold, the threshold is determined depending on experiences and according to several times of experiments, thus conventional detection method is not suitable for every wind field and every kind of blades.

At present, the blade imbalance of the wind power generator system may be detected via a detection means such as video analysis, vibration detection, and electrical information. However, in most of these methods, it is required to arrange an additional device, which results in not only a high cost, but also poor reliability and adaptability. Recently, researches relating blade imbalance are performed by many research institutions and wind machine manufacturers, and some patent applications are also filed. For example, in a patent titled "METHOD FOR DETECTING IMBLANCE FAULT IN IMPLLER BASED ON STATOR CURRENT OF A DIUBLY FED WIND POWER GENERATOR SYSTEM", in order to acquire a feature amplitude, it is required to perform secondary derivation to reconstruct a stator current and perform two times of FFT transform, resulting in a complicated processing process. For example, in a patent titled "METHOD FOR DETECTING IMBLANCE FAULT AMONG BLADES OF DOUBLY-FED WIND POWER GENERATOR", it is required to collect a voltage and a current, and perform process on the electric power, which may be feasible in theory, while have a poor adaptability for wind fields at different regions, blades of different manufactures and operating conditions of different wind machines.

Patent application No. CN105756864A relates to a blade imbalance fault diagnosis method based on a stator current of a double-fed wind generating set. The blade imbalance fault diagnosis method includes: controlling the double-fed wind generating set to operate in a detection mode, and keeping the wind generating set to operate at a constant rotating speed; synchronously acquiring a set stator phase current $i_A$ and a generator rotating speed r in the constant-speed operating stage, which meet requirements; according to the acquired generator rotating speed r, calculating a base frequency of an impeller speed, performing signal processing by using an envelope spectrum to obtain an envelope spectrum If after performing wavelet filtering processing on the stator phase current $i_A$; extracting a base frequency amplitude M(1) and a k-multiple frequency amplitude M(k) of the impeller speed in the envelope spectrum If and using the base frequency amplitude M(1) and the k-multiple frequency amplitude M(k) of the impeller speed as features, where k represents the number of blades; comparing the base frequency amplitude M(1) and the k-multiple frequency amplitude M(k), and if M(1) is greater than a*M(k), determining that blade imbalance exists, where a represents a preset amplitude ratio.

Patent application US2011036166 discloses a method and to determine the degree of residual mass unbalance and a corrective balance solution for a rotating assembly having a non-vertical axis of rotation. The method consists of measuring the average instantaneous real power over an interval of time, calculating the Fourier Transform of the demodulated signal, establishing the peak amplitude and phase associated with the angular velocity of the rotating assembly and calculating the amount of unbalance. The method to provide for a corrective solution consists of simultaneously acquiring a position reference signal of the rotating assembly with the average instantaneous real power signal, calculating the phase difference between the two acquired signals at the angular velocity of the rotating assembly, calculating the magnitude of the unbalance, and calculating the quantity and location of corrective weight necessary to minimize the unbalance to an acceptable level.

Patent application DE102011086608 discloses a method for determining the rotational speed of the rotor of a wind turbine and/or for monitoring the state of a rotor blade of a wind turbine. The rotational speed of the rotor is determined by ascertaining the period of oscillation of the motor current. The rotor position is determined by way of zero point evaluation and gradient evaluation, and/or the state of the rotor blade is determined with the aid of a time or frequency analysis of the motor current of at least one blade adjustment motor.

Patent application No. CN104184383 discloses a doubly-fed wind power generator stator current diagnosis method for an impeller imbalance fault. The fundamental frequency of the stator single-phase current is extracted by utilizing FFT analysis. The fault characteristic component of the stator single-phase current under the impeller imbalance fault is calculated using the fundamental frequency. An FFT is used to obtain a spectral analysis on an obtained fault characteristic component of the stator phase current. Characteristic frequency amplitude values of the wind generation set under normal circumstances are compared to judge the severity of the fault.

Patent application No. US2016033580A1 relates to detecting faults in Turbine Generators, turbine generator faults can be detected by receiving a current signal from the turbine generator, and synchronously sampling the current signal to obtain a set of current signal samples that are evenly spaced in the phase domain, in which phase differences between adjacent current signal samples in the set of current signal samples are substantially the same. The process includes generating a frequency spectrum of the current signal samples, identifying one or more excitations in the frequency spectrum, and detecting a fault in the turbine generator based on the one or more excitations in the frequency spectrum.

## SUMMARY

In order to overcome disadvantages in accuracy and adaptability of a conventional method for detecting blade imbalance of a doubly-fed wind power generator system, a method for detecting blade imbalance of a doubly-fed wind power generator system based on stator current data is provided in the present application, which is performed easily and achieves good accuracy and adaptability.

The following technical solution is provided in the present application, to solve the above technical problems.

A method for detecting blade imbalance of a doubly-fed wind power generator system based on stator current data is provided, which includes the following steps of:

1) collecting, on a condition of blade balance, multiple sets of data during a time period where the doubly-fed wind power generator system operates at a constant rotational speed, each of the multiple sets of data including a stator phase current $i_A$ and a rotational speed r, and performing a Hilbert transform on the stator phase current $i_A$, to obtain an amplitude envelope signal, where no pitch operation is performed in collecting the data;

2) performing a FFT transform on the amplitude envelope signal obtained in step 1, and calculating a base rotational frequency $f(1)$ of an impeller based on the rotational speed $r$ of the doubly-fed wind power generator system;

3) determining an amplitude at the base rotational frequency of the impeller based on results obtained in steps 1) and 2), and performing a fitting operation to obtain a curve for showing a relationship between the amplitude at the base rotational frequency and the stator phase current in the case of blade balance;

4) collecting the stator phase current $i_A$ and the rotational speed $r$ during the time period where the doubly-fed wind power generator system operates at the constant rotational speed, and calculating an amplitude $Q(1)$ at the base rotational frequency according to steps 1) and 2);

5) calculating $Q\_base(1)$ based on the stator phase current collected in step 4) in conjunction with the curve obtained in step 3), where $Q\_base(Y)$ indicates a reference amplitude at the base rotational frequency; and

6) comparing $Q(1)$ with $Q\_base(1)+offset$, and determining that there is the blade imbalance in a case that $Q(1) > Q\_base(1)+offset$, where an imbalance degree is calculated based on a difference between $Q(1)$ and $Q\_base(1)+offset$, and where the *offset* indicates a residual compensation and is determined based on theoretical analysis and the collected plurality sets of data in combination with an influence of residual in the least square method.

Further, in step 1), during the time period where the doubly-fed wind power generator system operates at the constant rotational speed, a root mean square value of the rotational speed is within a set range, which ranges from 0 to 15.

Further, in step 2), the base rotational frequency $f(1)$ of the impeller is calculated based on the rotational speed $r$ of the doubly-fed wind power generator system according to the following equation:

$$f(1) = \frac{r}{60 \times b} \qquad\qquad (1)$$

where $r$ indicates the rotational speed of the doubly-fed wind power generator system, b indicates a gearbox ratio.

Further, in step 3), the fitting operation is performed with the least square method according to the following equation:

$$\varphi(x) = a_0\varphi_0(x) + a_1\varphi_1(x) + \cdots + a_n\varphi_n(x) \qquad\qquad (2)$$

where $\varphi(x)$ indicates a function to be determined, $\{\varphi_0(x), \varphi_1(x), \cdots \varphi_n(x)\}$ indicates a function class, and $a_0, a_1, \cdots a_n$ indicate coefficients to be determined, and

$$P = \min_{\varphi(x) \in \varphi} \sum_{i=1}^{m} [\varphi(x_i) - y_i]^2 \qquad\qquad (3)$$

where P indicates a minimum value of a quadratic sum of a difference between determined data and actual data.

The following beneficial effects can be achieved in the present application. In one hand, it is unnecessary to arrange another device for collecting data, leading to a low hardware cost. In the other hand, an amplitude for a fault is small, and varies depending on an operation condition. In this application, a reference amplitude is obtained by a fitting operation, and a determination is made by comparing an actual amplitude with the reference amplitude, thereby eliminating interference of noises. In addition, the detection rate is improved due to error compensation.

## BRIEF DESCRIPTION OF THE DRAWINGS

In order to illustrate more clearly the technical solutions in the embodiments of the present application, the drawings to be used in the description of the embodiments are briefly described hereinafter. It is apparent that, the drawings described hereinafter are only some embodiments of the present application, other drawings may be obtained by those skilled in the art based on the drawings without any creative effort.

Figure 1 is a flowchart of a method according to the present application;

Figure 2 is a flow chart of a signal analysis process;

Figure 3 is a curve graph showing a torque and a rotational speed of a doubly-fed wind power generator system in a case of blade balance;

Figure 4 is a curve graph showing a stator phase current A and a rotational speed curve of a doubly-fed wind power generator system in a case of blade balance;

Figure 5 is a curve graph showing comparison between amplitudes obtained by performing a FFT transform on the phase currents A respectively in a case of blade balance and in a case of blade imbalance;

Figure 6 is a curve graph showing a comparison between spectrums obtained by performing a Hilbert transform respectively in a case of blade balance and in a case of blade imbalance;

Figure 7 is a curve graph showing relationships between a feature amplitude and an effective amplitude of a phase current respectively in a case of blade balance and in a case of blade imbalance; and

Figure 8 is a curve graph showing a comparison among detection results determined respectively in three cases of blades.

## DETAILED DESCRIPTION

The present application is described in conjunction with the drawings hereinafter.

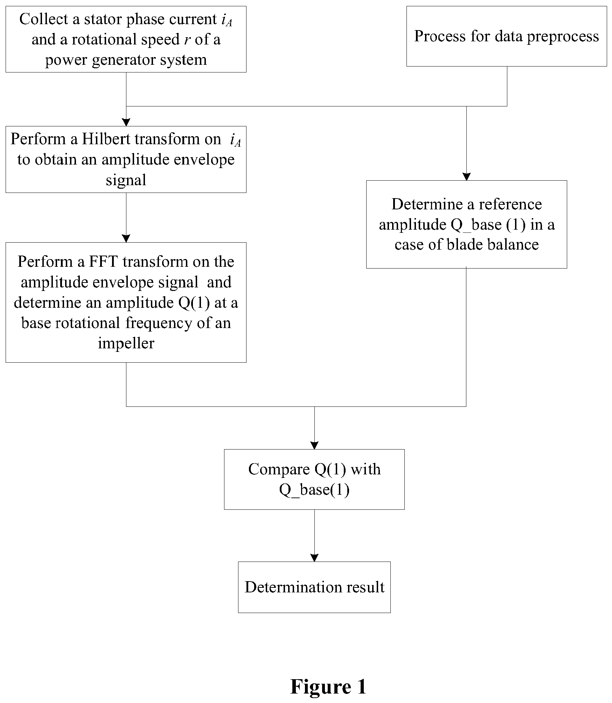

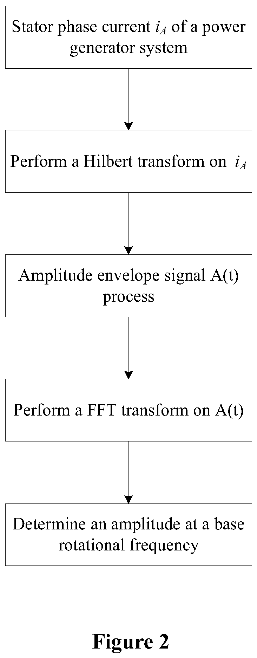

Referring to Figures 1 to 8, a method for detecting blade imbalance of a doubly-fed wind power generator system based on stator current data is provided, which includes the following steps 1) to 6).

In step 1), on a condition of blade balance, a stator phase current $i_A$ and a rotational speed $r$ of the doubly-fed wind power generator system are collected during a time period where the doubly-fed wind power generator system operates around a constant rotational speed. In a case of blade imbalance, the stator current may be affected. Description is made by taking an imbalance in mass as an example. It is assumed that a mass block m is arranged at a position of a blade away from a wheel hub for a distance R, an aerodynamic torque in this case may be determined according to the following equation:

$$T_m = T_0 + mgR\sin(\omega_m t + \varphi_0) \qquad (4)$$

where $T_m$ indicates an output torque of the doubly-fed wind power generator system, $\omega_m$ indicates a rotational speed of an impeller, $\varphi_0$ indicates an initial phase. Step 1) further includes the following steps 1.1) to 1.4).

In step 1.1), based on the equation (4) and in combination with a rotor motion equation, an electromagnetic torque may be obtained according to the following equation:

$$T_e = T_{e0} + VT_e \sin(\omega_m t + \varphi_{e0}) \qquad (5)$$

where $T_e$ indicates the electromagnetic torque of the wind power generator system, $VT_e$ indicates an amplitude of an imbalance torque, $\varphi_{e0}$ indicates an initial phase. It may be seen that there is an oscillation component in an electromagnetic torque.

In step 1.2), in a case that a direction of a voltage in the power grid is determined, a generator convention is used at a stator side, and a motor convention is used at a rotor side, a coordinate transformation is performed to obtain an expression of the electromagnetic torque in a dq coordinate system. Thus, the stator current $i_{sd}$ along a d axis is obtained according to the following equation:

$$i_{sd} = i_{sd0} + Vi_{sd} \sin(\omega_m t + \varphi_{sd}) \qquad (6)$$

where $i_{sd}$ indicates a current along the d axis, $Vi_{sd}$ indicates an amplitude of the oscillating component, $\varphi_{sd}$ indicates an initial phase.

In step 1.3), based on step 1.2), a stator voltage equation and a flux linkage in the dq coordinate system may be represented by the following equations (7) and (8), respectively. A stator current along a q axis may be determined according to the equation (6).

$$\begin{cases} u_{sd} = -R_s i_{sd} - p\psi_{sd} + \omega_1 \psi_{sq} \\ u_{sq} = -R_s i_{sq} - p\psi_{sq} - \omega_1 \psi_{sd} \end{cases} \qquad (7)$$

$$\begin{cases} \psi_{sd} = 0 \\ \psi_{sq} = \psi_s \approx \dfrac{U_s}{\omega_1} \end{cases} \qquad (8)$$

$$i_{sq} = i_{sq0} + Vi_{sq} \sin(\omega_m t + \varphi_{sq}) \qquad (9)$$

In step 1.4), a coordinate transformation is performed on the stator current in the dq coordinate system, to obtain the stator phase current $i_A$ in the abc coordinate system.

$$i_{sa} = i_{s0} \sin(\omega_1 t + \varphi_0) + \left\{ \frac{1}{3} V i_{sd} \sin[(\omega_m + \omega_1)t + \varphi_{sd} + \varphi_0] + \frac{1}{3} V i_{sq} \cos[(\omega_m + \omega_1)t + \varphi_{sq} + \varphi_0] \right\}$$

$$+ \left\{ \frac{1}{3} V i_{sd} \sin[(\omega_m - \omega_1)t + \varphi_{sd} - \varphi_0] - \frac{1}{3} V i_{sq} \cos[(\omega_m - \omega_1)t + \varphi_{sq} - \varphi_0] \right\} \qquad (10)$$

$$= i_{sa0} + i_{sa+} + i_{sa-}$$

It can be seen from the equation (10) that, a harmonic component $f \pm f_m$ may be generated in the stator current in the case of blade imbalance.

The Hilbert transform is performed on collected data, and the FFT transform is performed on an amplitude envelope signal.

The Hilbert transform is performed on the stator phase current $i_A$, to obtain a signal $i_B$, so as to obtain an analysis signal $Z(t)$, and an amplitude envelope signal $A(t)$ is determined based on the analysis signal.

$$i_B(t) = \frac{1}{\pi} \int_{-\infty}^{+\infty} \frac{x(\tau)}{t - \tau} d\tau = x(t) \frac{1}{\pi t} \qquad (11)$$

where $i_B(t)$ indicates an output obtained by performing the Hilbert transform on $i_A(t)$.

$$Z(t) = i_A(t) + j i_B(t) \qquad (12)$$

where $Z(t)$ indicates an analysis function.

$$A(t) = \sqrt{(i_A(t))^2 + (i_B(t))^2} \qquad (13)$$

where $A(t)$ indicates an amplitude envelope signal of the stator phase current $i_A$.

In step 2), a FFT transform is performed on the amplitude envelope signal obtained in step 1, and a base rotational frequency $f(1)$ of the impeller is calculated based on the rotational speed $r$ of the wind power generator system according to the following equation:

$$f(1) = \frac{r}{60 \times b} \qquad (1)$$

In step 3), the FFT transform is performed on the amplitude envelope signal A(t) to obtain a frequency spectrum signal, and an amplitude at the base rotational speed of the impeller is determined. A fitting operation is performed with the least square method to obtain a curve for showing a relationship between the amplitude at the base rotational frequency and the stator phase current in the case of blade balance according to the following equation:

$$\varphi(x) = a_0 \varphi_0(x) + a_1 \varphi_1(x) + \cdots + a_n \varphi_n(x) \qquad (2)$$

where $\varphi(x)$ indicates a function to be determined, $\{\varphi_0(x), \varphi_1(x), \cdots \varphi_n(x)\}$ indicates a function class, and $a_0, a_1, \cdots a_n$ indicate coefficients to be determined.

$$P = \min_{\varphi(x) \in \varphi} \sum_{i=1}^{m} [\varphi(x_i) - y_i]^2 \qquad (3)$$

where P indicates a minimum value of a quadratic sum of a difference between determined data and an actual data.

In step 4), the stator phase current and the rotational speed are collected in a case that the doubly-fed wind power generator system operates, and a feature amplitude $Q(1)$ at the base rotational frequency of the wind power generator system is determined according to steps 1) and 2).

In step 5), a reference amplitude $Q\_base(1)$ under the operation condition is determined based on the stator current data collected in step 4) in conjunction with the curve obtained in step 3).

In step 6), the $Q(1)$ is compared with the $Q\_base(1)$, and it is determined that there is blade imbalance if $Q(1) > Q\_base(1)+offset$ .

The parameters involved in the embodiment may be obtained from sensors arranged in the wind power generator system, and it is unnecessary to arrange another device, such that a detection cost is low.

The amplitude of the fault is small, and varies depending on the operation condition. In this application, a reference amplitude is obtained by a fitting operation, and a determination is made by comparing an actual amplitude with the reference amplitude, thereby eliminating interference of noise. In addition, error compensation is performed, which improves the detection rate.

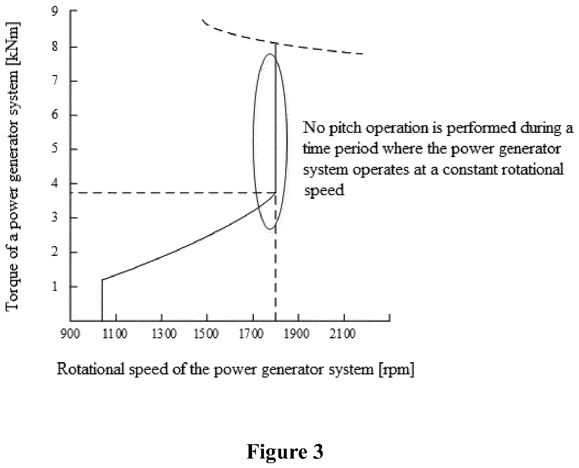

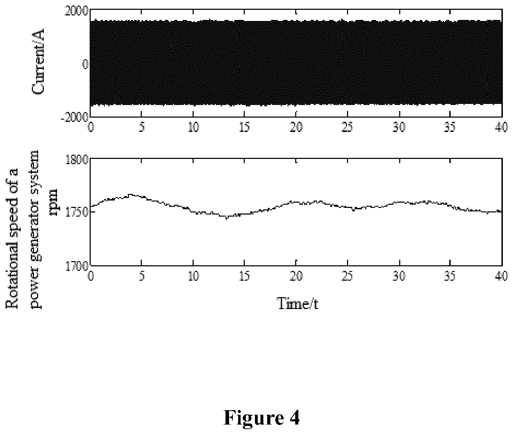

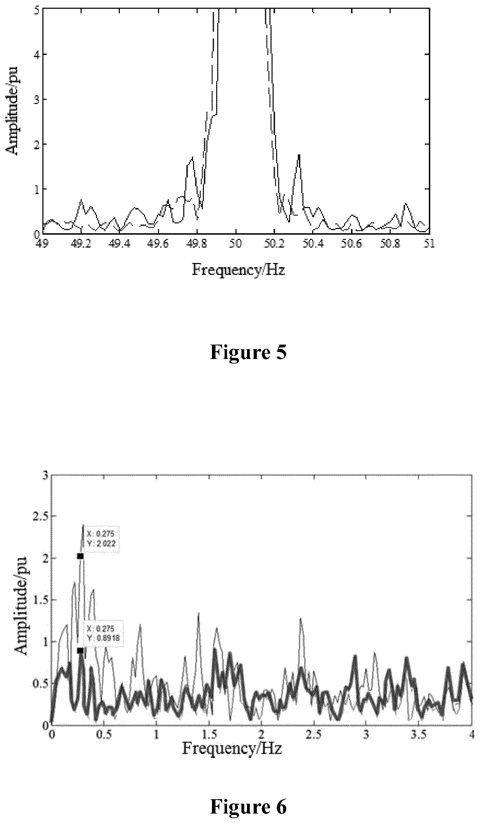

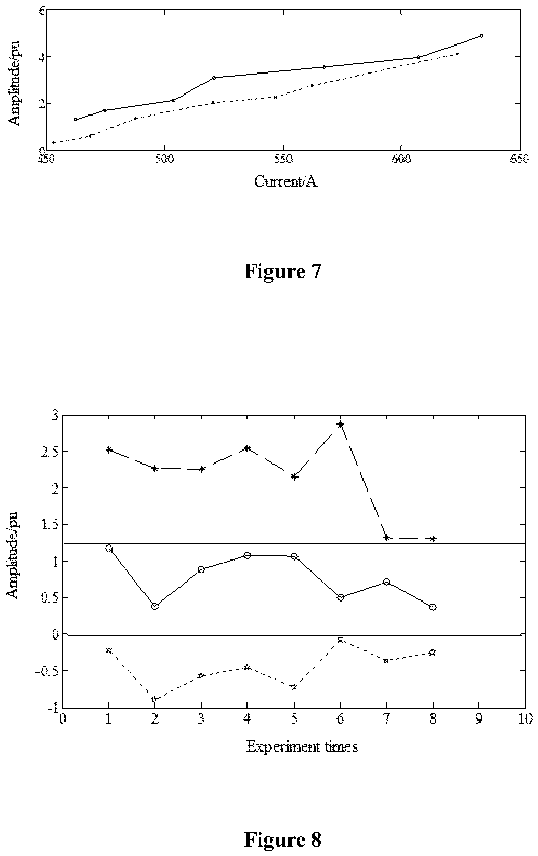

Taking a 1.5MW doubly-fed wind power generator system with three blades as an example. In a case that the doubly-fed wind power generator system operates at a constant rotational speed, that is, a rotational speed around 1750rpm, an operating range is as shown in Figure 3. The rotational speed and the stator phase current of the doubly-fed wind power generator system around the constant rotational speed are collected, and signal analysis is performed on the collected rotational speed and stator phase current, waveforms of the stator phase current and the rotational speed in a time domain are as shown in Figure 4. Figure 5 is a curve graph showing the stator phase current in a frequency domain respectively in the case of blade balance and in the case of blade imbalance. It can be seen apparently from Figure 5 that there is a difference at the frequency $f = 50 \pm 0.275 Hz$ between amplitudes in the two cases, and an amplitude in the case of blade imbalance is larger than an amplitude in the case of blade balance. In order to further eliminate the noise and collect the feature parameter accurately, the Hilbert transform is performed to obtain an amplitude envelope signal, and the FFT transform is performed on the amplitude envelope signal, the spectrum is as shown in Figure 6. Figure 7 is a curve graph showing relationships between the feature amplitude and the stator phase current A respectively in the case of blade balance and in the case of blade imbalance, a solid line indicates a curve in the case of blade balance and a dotted line indicates a curve in the case of blade imbalance, and it can be seen apparently that the feature amplitude increases significantly with an increase of an output power at a stator side.

It is to be noted that, the case that the wind power generator system operates at a constant rotational speed mentioned herein indicates that the wind power generator system operates at a rotational speed ranging from 1700rpm to 1800rpm, and no pitch is performed. In this case, the output power of the wind power generator system is close to a rated power. If the pitch is performed in the case that the wind power generator system operates at a constant rotational speed, it may be difficult to collect the fault information.

The following three cases are described as an example. In a first case, there is blade balance. In a second case, a propeller pitch angle of one blade has a deviation of two degrees. In a third case, a propeller pitch angle of one blade has a deviation of four degrees. In the above three cases, during a time period where the wind power generator system operates at a constant rotational speed, the stator phase current and the rotational speed of the wind power generator system are collected for analysis. In a case that the wind power generator system operates at a constant rotational speed, multiple sets of data each including the stator phase current and the rotational speed are to be collected.

Eight sets of data are collected for each of the above three cases, thus twenty four sets of data are obtained. The twenty four sets of data are analyzed with the method of the present application, and $Q(1)$ is compared with $Q\_base(1)+offset$. Figure 8 is a statistical graph showing results determined respectively in the above three cases, the horizontal coordinate indicates the number of sets of data and the longitudinal coordinate indicates a difference between $Q(1)$ and $Q\_base(1)+offset$.

A lower part of Figure 8 shows data obtained in the case of blade balance, a middle part of Figure 8 shows data obtained in the case that a propeller pitch angle of one blade has a deviation of two degrees, and an upper part shows data obtained in the case that a propeller pitch angle of one blade has a deviation of four degrees. It can be seen from Figure 8 that, the amplitude is less than or close to zero in the case of blade balance, the amplitude is greater than zero in the case of blade imbalance, and a large imbalance degree corresponds to a large amplitude. Therefore, it may be determined whether there is blade imbalance based on an amplitude for a detection object along the longitudinal coordinate. Considering that different blades have different structures and aerodynamic designs, the *offset* for a blade should be determined based on the theoretical analysis and actually measured data in combination with the influence of residual in the least square method.

It can be determined from a large amount of experimental data that, the difference between $Q(1)$ and $Q\_base(1)+offset$ is less than zero in the case of blade balance, the difference is greater than zero in the case of blade imbalance. Therefore, in the present application, it may be determined whether there is blade imbalance based on the difference between $Q(1)$ and $Q\_base(1)+offset,$ that is, in a case that the difference is larger than zero, it may be determined that there is blade imbalance. The determination method of the present application is obtained based on a large amount of experimental data and is not limited to this example.

In the present application, it is determined whether there is blade imbalance based on the rotational speed and the stator phase current of the doubly-fed wind power generator system, the required data may be collected by a data collecting device of the wind power generator system. The doubly-fed wind power generator system may operate in a detection mode for a short time period, effective data packet may be quickly obtained, which is simple and effective, and has a low detection cost, such that the method in the present application is effective and reliable in detection an imbalance among blades.

Finally, it should be noted that the above embodiments are only used to illustrate the technical solution of the present application rather than a limit, it is to be understood by those skilled in the art that various modification and variations may be made to these embodiments without departing from the scope of the present application defined by appended claims.

**Claims**

1. A method for detecting blade imbalance of a doubly-fed wind power generator system based on stator current data, comprising steps of:

   1) collecting, on a condition of blade balance, a plurality sets of data during a time period where the doubly-fed wind power generator system operates at a constant rotational speed, each of the plurality sets of data comprising a stator phase current $i_A$ and a rotational speed r, and performing a Hilbert transform on the stator phase current $i_A$, to obtain an amplitude envelope signal, wherein no pitch operation is performed in collecting the data;
   2) performing a FFT transform on the amplitude envelope signal obtained in step 1, and calculating a base rotational frequency $f(1)$ of an impeller based on the rotational speed r of the doubly-fed wind power generator system;
   3) determining an amplitude at the base rotational frequency of the impeller based on results obtained in steps 1) and 2), and performing a fitting operation with a least square method to obtain a curve for showing a relationship between the amplitude at the base rotational frequency and the stator phase current in the case of blade balance;
   4) collecting the stator phase current $i_A$ and the rotational speed r during the time period where the doubly-fed wind power generator system operates at the constant rotational speed, and calculating an amplitude $Q(1)$ at the base rotational frequency according to steps 1) and 2);
   5) calculating $Q\_base(1)$ based on the stator phase current collected in step 4) in conjunction with the curve obtained in step 3), wherein $Q\_base(1)$ indicates a reference amplitude at the base rotational frequency; and
   6) comparing $Q(1)$ with $Q\_base(1)+offset$, and determining that there is the blade imbalance in a case that $Q(1) > Q\ base(1)+offset$, wherein an imbalance degree is calculated based on a difference between $Q(1)$ and $Q\_base(1)+offset$, and wherein the *offset* indicates a residual compensation and is determined based on theoretical analysis and the collected plurality sets of data in combination with an influence of residual in the least square method.

2. The method for detecting blade imbalance of a doubly-fed wind power generator system based on stator current data according to claim 1, wherein
   in step 1), during the time period where the doubly-fed wind power generator system operates at the constant rotational speed, a root mean square value of the rotational speed is within a set range.

3. The method for detecting blade imbalance of a doubly-fed wind power generator system based on stator current data according to claim 1or 2, wherein

   in step 2), the base rotational frequency $f(1)$ of the impeller is calculated based on the rotational speed r of the doubly-fed wind power generator system according to the following equation:

$$f(1) = \frac{r}{60 \times b} \qquad\qquad (1)$$

   where r indicates the rotational speed of the doubly-fed wind power generator system, b indicates a gearbox ratio.

4. The method for detecting blade imbalance of a doubly-fed wind power generator system based on stator current data according to claim 1or 2, wherein

in step 3), the fitting operation is performed with the least square method according to the following equation:

$$\varphi(x) = a_0\varphi_0(x) + a_1\varphi_1(x) + \cdots + a_n\varphi_n(x) \qquad (2)$$

where $\varphi(x)$ indicates a function to be determined, $\{\varphi_0(x), \varphi_1(x), \cdots \varphi_n(x)\}$ indicates a function class, and $a_0, a_1, \cdots a_n$ indicate coefficients to be determined, and

$$P = \min_{\varphi(x) \in \varphi} \sum_{i=1}^{m} [\varphi(x_i) - y_i]^2 \qquad (3)$$

where P indicates a minimum value of a quadratic sum of a difference between determined data and actual data.

**Patentansprüche**

1. Verfahren zum Erkennen von Blattunwucht eines doppelt gespeisten Windkraftgeneratorsystems basierend auf Statorstromdaten, das die Schritte umfasst:

1) Sammeln mehrerer Datensätze unter der Bedingung der Laufruhe des Blatts während eines Zeitraums, in dem das doppelt gespeiste Windkraftgeneratorsystem mit einer konstanten Drehzahl arbeitet, wobei jeder der mehreren Datensätze einen Statorphasenstrom $i_A$ und eine Drehzahl r umfasst, und Durchführen einer Hilbert-Transformation des Statorphasenstroms $i_A$, um ein Amplitudenhüllkurvensignal zu erhalten, wobei beim Sammeln der Daten keine Neigungsoperation durchgeführt wird;
2) Durchführen einer FFT-Transformation des in Schritt 1 erhaltenen Amplitudenhüllkurvensignals und Berechnen einer Basisdrehfrequenz $f(1)$ eines Laufrads basierend auf der Drehzahl $r$ des doppelt gespeisten Windkraftgeneratorsystems;
3) Bestimmen einer Amplitude bei der Basisdrehfrequenz des Laufrads basierend auf der in den Schritten 1) und 2) erhaltenen Ergebnisse, und Durchführen eines Anpassungsvorgangs mit einem Verfahren der kleinsten Quadrate, um eine Kurve zu erhalten, die eine Beziehung zwischen der Amplitude bei der Basisdrehfrequenz und dem Statorphasenstrom im Fall einer Laufruhe des Blatts zeigt;
4) Sammeln des Statorphasenstroms $i_A$ und der Drehzahl $r$ während des Zeitraums, in dem das doppelt gespeiste Windkraftgeneratorsystem mit der konstanten Drehzahl arbeitet, und Berechnen einer Amplitude $Q(1)$ bei der Basisdrehfrequenz nach den Schritten 1) und 2);
5) Berechnen von $Q\_Basis(1)$ basierend auf dem in Schritt 4) gesammelten Statorphasenstrom in Verbindung mit der in Schritt 3) erhaltenen Kurve, wobei $Q\_Basis(1)$ eine Referenzamplitude bei der Basisdrehfrequenz angibt; und
6) Vergleichen von $Q(1)$ mit *Q\_Basis(1)+Offset,* und Bestimmen, dass die Blattunwucht in einem Fall vorliegt, in dem *Q(1) > Q\_Basis(1)+Offset,* wobei ein Unwuchtgrad basierend auf einer Differenz zwischen Q(1) und *Q\_Basis(1)+Offset* berechnet wird, und wobei der *Offset* eine Restkompensation angibt und basierend auf einer theoretischen Analyse und den gesammelten mehreren Datensätzen in Kombination mit einem Einfluss des Rests in dem Verfahren der kleinsten Quadrate bestimmt wird.

2. Verfahren zum Erkennen einer Blattunwucht eines doppelt gespeisten Windkraftgeneratorsystems basierend auf Statorstromdaten nach Anspruch 1, wobei
in Schritt 1) während des Zeitraums, in dem das doppelt gespeiste Windkraftgeneratorsystem mit der konstanten Drehzahl arbeitet, ein quadratischer Mittelwert der Drehzahl innerhalb eines festgelegten Bereichs liegt.

3. Verfahren zum Erkennen einer Blattunwucht eines doppelt gespeisten Windkraftgeneratorsystems basierend auf Statorstromdaten nach Anspruch 1 oder 2, wobei

in Schritt 2) die Basisdrehfrequenz $f(1)$ des Laufrads basierend auf der Drehzahl r des doppelt gespeisten Windkraftgeneratorsystems nach der folgenden Gleichung berechnet wird:

$$f(1) = \frac{r}{60xb} \qquad (1)$$

wobei r die Drehzahl des doppelt gespeisten Windkraftgeneratorsystems und b die Getriebeübersetzung angibt.

4. Verfahren zum Erkennen einer Blattunwucht eines doppelt gespeisten Windkraftgeneratorsystems basierend auf Statorstromdaten nach Anspruch 1 oder 2, wobei

in Schritt 3) der Anpassungsvorgang mit dem Verfahren der kleinsten Quadrate nach der folgenden Gleichung durchgeführt wird:

$$\varphi(x) = a_0\varphi_0(x) + a_1\varphi_1(x) + \cdots + a_n\varphi_n(x) \qquad (2)$$

wobei $\varphi(x)$ eine zu bestimmende Funktion, $\{\varphi_0(x), \varphi_1(x), \cdots \varphi_n(x)\}$ eine Funktionsklasse, und $a_0, a_1, \cdots a_n$ zu bestimmende Koeffizienten angeben, und

$$p = \min_{\varphi(x)\epsilon\varphi} \sum_{i=1}^{m} [\varphi(x_i) - y_i]^2 \qquad (3)$$

wobei P den Mindestwert der quadratischen Summe der Differenz zwischen den ermittelten Daten und den tatsächlichen Daten angibt.

## Revendications

1. Procédé pour la détection d'un déséquilibre de pale d'un système générateur d'énergie éolienne à double alimentation sur la base de données de courant de stator, comprenant les étapes suivantes :

   1) collecter, dans une condition d'équilibre de pale, une pluralité d'ensembles de données pendant une durée au cours de laquelle le système générateur d'énergie éolienne à double alimentation fonctionne à une vitesse de rotation constante, chacun de la pluralité d'ensembles de données comprenant un courant de phase de stator $i_A$ et une vitesse de rotation $r$, et réaliser une transformée de Hilbert sur le courant de phase de stator $i_A$, pour obtenir un signal d'enveloppe d'amplitude, dans lequel aucune opération sur le pas n'est réalisée lors de la collecte des données ;
   2) réaliser une transformée de Fourier rapide, FFT, sur le signal d'enveloppe d'amplitude obtenu à l'étape 1, et calculer une fréquence de rotation de base $f(1)$ d'un rotor sur la base de la vitesse de rotation r du système générateur d'énergie éolienne à double alimentation ;
   3) déterminer une amplitude à la fréquence de rotation de base du rotor sur la base de résultats obtenus aux étapes 1) et 2), et réaliser une opération d'ajustement avec une méthode des moindres carrés pour obtenir une courbe pour représenter une relation entre l'amplitude à la fréquence de rotation de base et le courant de phase de stator dans le cas d'un équilibre de pale ;
   4) collecter le courant de phase de stator $i_A$ et la vitesse de rotation $r$ pendant la durée au cours de laquelle le système générateur d'énergie éolienne à double alimentation fonctionne à la vitesse de rotation constante, et calculer une amplitude $Q(1)$ à la fréquence de rotation de base selon les étapes 1) et 2) ;
   5) calculer $Q\_base(1)$ sur la base du courant de phase de stator collecté à l'étape 4) en conjonction avec la courbe obtenue à l'étape 3), dans lequel $Q\_base(1)$ indique une amplitude de référence à la fréquence de rotation de base ; et
   6) comparer $Q(1)$ avec $Q\_base(1) + décalage,$ et déterminer que le déséquilibre de pale est présent dans un cas où $Q(1) > Q\_base(1) + décalage,$ dans lequel un degré de déséquilibre est calculé sur la base d'une différence entre $Q(1)$ et $Q\_base(1) + décalage,$ et dans lequel le décalage indique une compensation résiduelle et est déterminé sur la base d'une analyse théorique et de la pluralité d'ensembles de données collectés en combinaison avec une influence de résidu dans la méthode des moindres carrés.

2. Procédé pour la détection d'un déséquilibre de pale d'un système générateur d'énergie éolienne à double alimentation sur la base de données de courant de stator selon la revendication 1, dans lequel à l'étape 1), pendant la durée au cours de laquelle le système générateur d'énergie éolienne à double alimentation fonctionne à la vitesse de rotation constante, une valeur de moyenne quadratique de la vitesse de rotation est au sein d'une plage définie.

3. Procédé pour la détection d'un déséquilibre de pale d'un système générateur d'énergie éolienne à double alimentation sur la base de données de courant de stator selon la revendication 1 ou 2, dans lequel

à l'étape 2), la fréquence de rotation de base $f(1)$ du rotor est calculée sur la base de la vitesse de rotation $r$ du système générateur d'énergie éolienne à double alimentation selon l'équation suivante :

$$f(1) = \frac{r}{60 \times b} \qquad (1)$$

où $r$ indique la vitesse de rotation du système générateur d'énergie éolienne à double alimentation, b indique un rapport de transmission.

4. Procédé pour la détection d'un déséquilibre de pale d'un système générateur d'énergie éolienne à double alimentation sur la base de données de courant de stator selon la revendication 1 ou 2, dans lequel

à l'étape 3), l'opération d'ajustement est réalisée avec la méthode des moindres carrés selon l'équation suivante :

$$\varphi(x) = \alpha_0 \varphi_0(x) + \alpha_1 \varphi_1(x) + \dots + \alpha_n \varphi_n(x) \qquad (2)$$

où $\varphi(x)$ indique une fonction devant être déterminée, $\{\varphi_0(x), \varphi_1(x), \dots \varphi_n(x)\}$ indique une classe de fonction, et $\alpha_0, \alpha_1, \dots \alpha_n$ indiquent des coefficients devant être déterminés, et

$$P = \min_{\varphi(x) \in \varphi} \sum_{i=1}^{m} [\varphi(x_i) - y_i]^2 \qquad (3)$$

où P indique une valeur minimale d'une somme quadratique d'une différence entre des données déterminées et des données réelles.

Collect a stator phase current $i_A$ and a rotational speed $r$ of a power generator system

Process for data preprocess

Perform a Hilbert transform on $i_A$ to obtain an amplitude envelope signal

Perform a FFT transform on the amplitude envelope signal and determine an amplitude Q(1) at a base rotational frequency of an impeller

Determine a reference amplitude Q_base (1) in a case of blade balance

Compare Q(1) with Q_base(1)

Determination result

**Figure 1**

Stator phase current $i_A$ of a power generator system

↓

Perform a Hilbert transform on $i_A$

↓

Amplitude envelope signal A(t) process

↓

Perform a FFT transform on A(t)

↓

Determine an amplitude at a base rotational frequency

**Figure 2**

No pitch operation is performed during a time period where the power generator system operates at a constant rotational speed

**Figure 3**

**Figure 4**

**Figure 5**

**Figure 6**

**Figure 7**

**Figure 8**

**EP 3 557 050 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201611143926
- CN 105756864 A
- US 2011036166 A
- DE 102011086608
- CN 104184383
- US 2016033580 A1